Europäisches Patentamt

European Patent Office

Office européen des brevets

(19)

(11) Publication number: **0 678 925 A1**

# (12) EUROPEAN PATENT APPLICATION

(21) Application number: **95200635.1**

(22) Date of filing: **16.03.95**

(51) Int. Cl.6: **H01L  43/06**, H01L 43/08

(30) Priority: **18.04.94 US 228766**

(43) Date of publication of application:
**25.10.95 Bulletin  95/43**

(84) Designated Contracting States:
**BE DE FR GB NL**

(71) Applicant: **GENERAL MOTORS CORPORATION**
**General Motors Building**
**3044 West Grand Boulevard**
**Detroit**
**Michigan 48202 (US)**

(72) Inventor: **Partin, Dale Lee**
**20820 30 Mile Road**
**Ray,**
**Michigan 48096 (US)**

(74) Representative: **Denton, Michael John et al**
**Patent Section**
**1st Floor**
**Gideon House**
**28 Chapel Street**
**Luton**
**Bedfordshire LU1 2SE (GB)**

(54) **Magnetic field sensor.**

(57) A magnetic field sensor is described that incorporates an epitaxial, magnetically active layer of a ternary or quaternary alloy of indium antimonide having a high electron mobility. The magnetically active layer is grown on a substantially lattice-matched and higher energy band gap layer that is also of a ternary or quaternary alloy of indium antimonide.

EP 0 678 925 A1

## Field of the Invention

This invention relates to improvements in magnetic field sensors. In a preferred embodiment it relates to very thin film alloys of indium antimonide for magnetic field sensors.

## Background of the Invention

Indium antimonide (InSb) is widely recognized as being useful in magnetic field sensors, such as magnetoresistors, Hall effect sensors (Hall sensors), and MAGFETS. Indium antimonide magnetic field sensors can be used in a variety of magnetic field sensing applications, including position, speed and acceleration sensing (linear or angular), compass sensors, magnetic memory readout and control of brushless motors.

Indium antimonide is particularly attractive for use in magnetic field sensors because it is a material that has a high electron mobility. High electron mobility is important because it provides high magnetic sensitivity. On the other hand, indium antimonide has a relatively low energy band gap, of about 0.18 electron volts at room temperature. This relatively low energy band gap gives it a relatively large intrinsic carrier density at room temperature. However, in addition, the relatively large intrinsic carrier density increases dramatically with increases in temperature. This effect tends to mask resistance changes in the indium antimonide due to changes in magnetic field.

Often such temperature-induced changes can be compensated by signal conditioning circuitry. However, with indium antimonide, the temperature-induced changes in conductivity, or resistivity, are so large that they are not readily accommodated by the usual type of signal conditioning circuitry. Accordingly, it is typical to stabilize the carrier density in indium antimonide with respect to temperature variations by doping it n-type, typically within a factor of about 10 of $3 \times 10^{17}$ cm$^{-3}$. Conventional indium antimonide magnetoresistors are usually doped in a narrower range between about $4 \times 10^{16}$ cm$^{-3}$ and $2 \times 10^{17}$ cm$^{-3}$. However, higher values may be optional for some embodiments of this invention as will be described below. The n-type dopant is ordinarily tellurium, selenium, sulfur, silicon, tin or the like. This increases the electron density to sufficiently higher levels that changes in intrinsic carrier density (due to temperature changes) become insubstantial compared to the dopant density, or are more accommodatable with the usual signal conditioning circuitry.

On the other hand, the resulting n-type doped material has a lower electrical resistivity, or higher conductivity, than is desired. A higher resistance device draws less current at a given voltage, and therefore dissipates less power for a given voltage bias. Alternatively, it provides a larger output voltage (change in voltage when the magnetic field changes) for a given current bias. This favors use of thin films of indium antimonide for magnetic field sensors, to obtain sensors of lower power consumption.

In the past, thin layers of indium antimonide were made by thinning down high quality bulk monocrystals. They were thinned down to layers of approximately 20 micrometers in thickness. Thinner layers were desired for reducing series resistance of sensors made from such films. However, thinner layers were difficult to produce by thinning bulk crystals. This led to the more recent practice of growing a thin epitaxial film of indium antimonide on an insulating or semi-insulating gallium arsenide (GaAs) or indium phosphide (InP) substrate. The substrate is of high electrical resistance to minimize its nonmagnetically sensitive conductivity, that is electrically in parallel with the magnetically sensitive conductivity of the epitaxial film. Such epitaxial films are typically grown to a thickness of only 2 to 5 micrometers. This increases film sheet resistance (film resistivity divided by thickness) by an order of magnitude over the thinned-down bulk crystal films. However, even then, such films still have had such a low sheet resistance that other techniques are used to increase total sensor resistance. For example, extensive serialization of magnetoresistor units has been used to obtain high sensor resistances and the attendant low power consumption.

In the case of magnetoresistors, a higher total resistance is obtained by integrating many series-connected rectangular magnetoresistor units into one sensor body. Typically, the body is an elongated mesa or line of indium antimonide. The mesa is a line of rectangular sensing units that are connected end-to-end, in series fashion. The mesa or line, i.e., the series-connected magnetoresistor units, can be as long as needed to obtain the desired total resistance. Usually, the line is sinuous or undulated in order to get the greatest length on a unit area of gallium arsenide or indium phosphide substrate material.

The individual magnetoresistor rectangles have been integrally formed in an indium antimonide mesa strip, and concurrently integrally connected in series, by forming a plurality of transverse "shorting bars" along the length of the mesa strip. The "shorting bars" are ordinarily spaced a fixed distance apart, which forms a series of rectangles along the length of the mesa strip. In such a construction, net resistance in the resultant sensor is a function of the number of successive rectangles in the line.

In the past, increased sensor resistance was obtained by increasing the number of successive rectangles in the mesa or line. This, of course, increases line length, which can increase the size of the sensor in a unit area.

Alternatively, one or two electrical contacts may be added to the sides of a single rectangle and used to form a Hall effect sensor or a MAGFET sensor. These sensors may be used to measure the Hall effect voltage. This voltage increased with increasing magnetic field, is sensitive to the polarity of magnetic field, and is inversely proportional to the thickness of the active, or current-carrying, layer. Thus, it is desirable to make such sensors with a very thin active layer. The Hall effect voltage is also inversely proportional to the electron density in the active layer. Therefore, it is desirable to minimize the electron density in the active layer. However, the Hall voltage will be sensitive to temperature if the electron density is sensitive to temperature. Since indium antimonide and indium antimonide-rich alloys are narrow energy bandgap semiconductors, it is necessary to dope the active layer n-type in order to stabilize the electron density. Thus, many of the structures discussed here in connection with magnetoresistors are very well suited for Hall effect sensors and MAGFET sensors.

As indicated above, indium antimonide has been of interest as a magnetic field sensor material because it can be made with a high electron mobility. High electron mobility is obtained reproducibly only if the indium antimonide is monocrystalline and the indium antimonide is of high quality. By "high quality" it is meant that there are few crystal imperfections, such as dislocations, and the like. For example, less than about $3 \times 10^9$ cm$^{-2}$ threading dislocations is desirable. The density of misfit and threading dislocations is generally much larger near an interface with a large lattice mismatch.

When growing monocrystalline thin films on a substrate, high single crystal quality is obtained if the substrate itself is a high quality single crystal of the same type and has approximately the same crystal lattice constant (as the film being grown). In general, the better the crystalline match, the higher the quality of the epitaxial layer that can be grown. In addition, for highest magnetic sensitivity and lowest power consumption, the substrate is preferably electrically insulating. To satisfy these requirements and still other requirements, prior magnetoresistor indium antimonide epitaxial films have been typically grown on high quality monocrystalline wafers of gallium arsenide (GaAs) or indium phosphide (InP). Their large energy band gaps mean that their intrinsic carrier densities are extremely low, which facilitates making them electrically insulating.

On the other hand, gallium arsenide and indium phosphide are really somewhat smaller in crystal lattice size than indium antimonide. For example, the lattice constant of indium antimonide is 6.479 angstroms at room temperature. The lattice constant of indium phosphide is only 5.869 angstroms. Indium antimonide has a lattice constant that is about 10% larger. Analogously, the lattice constant of gallium arsenide is 5.654 angstroms. The indium antimonide lattice constant is about 14% larger.

As a result, the first 0.5 micrometer of an indium antimonide layer heretofore epitaxially deposited on a gallium arsenide or indium phosphide monocrystalline substrate was strained, and therefore had significant crystal imperfections. As a result, the electron mobility within that first 0.5 micrometer of deposited indium antimonide was of low electron mobility. As indicated above, this provided low magnetic sensitivity. In order to obtain higher electron mobility, and the higher magnetic sensitivity that it provided, an additional thickness was grown.

It should be recognized that the first 0.5 micrometer of the film is electrically in parallel with the balance of the film. Accordingly, a sufficient additional thickness had to be grown to provide a discernable magnetically variable total film resistance. Ordinarily, a total indium antimonide film thickness of at least about two micrometers was needed. On the other hand, if the indium antimonide thickness exceeded about five micrometers, the sheet resistance decreased to such an extent that size and/or power consumption of the resultant sensor became undesirable.

In this invention, a magnetic field sensor is provided having a magnetically active layer of gallium indium antimonide or indium aluminum antimonide or indium arsenide antimonide in thickness preferably below about 0.5 micrometer. All three of these ternary alloys are indium antimonide-rich and include the binary indium antimonide. However, in this invention these thicknesses have a mobility comparable to that currently available only with indium antimonide layers of thicknesses of about 2 to 5 micrometers and have higher sheet resistance. As a result, the subject magnetic field sensor affords lower power consumption per unit sensor area, and/or smaller sensors of given electrical resistance, and/or higher spatial resolution in sensing. It also makes it much easier to etch sub-micron patterns into an active region when the thickness of the active region is less than about 0.5 micrometer.

## Summary of the Invention

This invention provides an improved magnetic field sensor.

This invention also provides a method for making an improved magnetic field sensor.

This invention preferably provides a magnetoresistor having a high mobility active layer less than about 0.5 micrometers thick.

In a preferred embodiment this invention provides a magnetoresistor having an indium gallium antimonide or indium aluminum antimonide or indium arsenide antimonide active layer less than about 0.5 micrometer thick on an indium aluminum antimonide or indium gallium antimonide surface of a substrate wafer.

A magnetic field sensor in accordance with the present invention is characterized by the features specified in claim 1.

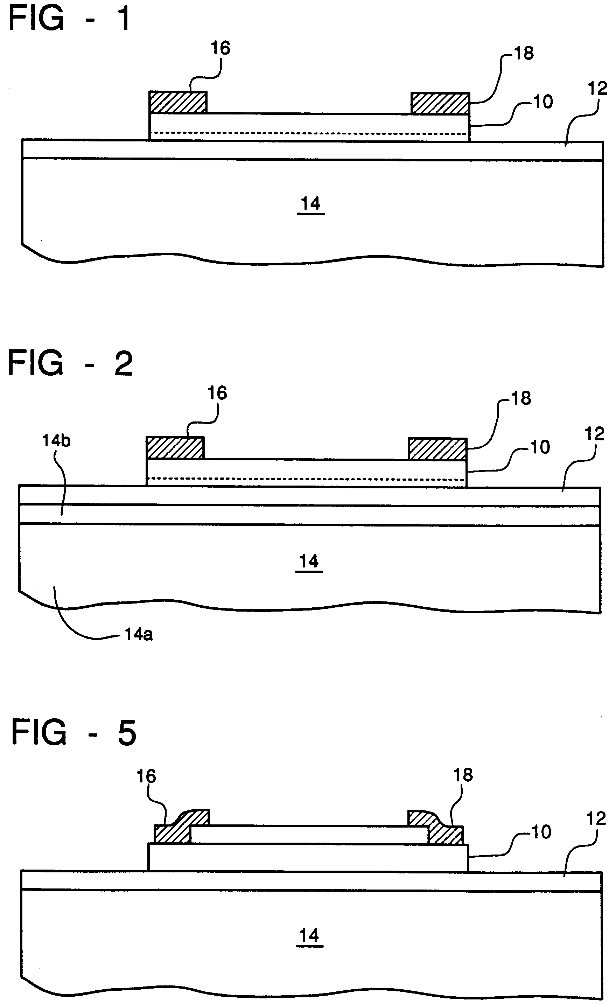

In a preferred embodiment this invention is practiced starting with a generally lattice mismatched monocrystalline semiconductor wafer having a lattice constant of at least about 5.4 and preferably at least about 5.9 angstroms. A buffer layer of a compound semiconductor is epitaxially deposited on the monocrystalline wafer to a thickness sufficient to provide an upper surface substantially free of crystal imperfections. The compound semiconductor is one having a lattice constant of greater than about 6.3 angstroms and also having an energy band gap greater than about 0.25 eV and typically in the range of about 0.3 to 0.6 eV at room temperature. A monocrystalline layer of, for example, gallium indium antimonide is epitaxially deposited on the previously deposited compound semiconductor buffer layer. The indium gallium antimonide $Ga_xIn_{1-x}Sb$ has $x \leq 0.2$ and typically $x \leq 0.1$ and has a thickness of up to about 0.5 micrometer. Such a layer provides electron mobility values typically of about 30,000 $cm^2V^{-1}s^{-1}$ or more, depending upon the electron density, thickness, defect densities, etc. If layer 10 (referring to Figure 1) is $InAs_xSb_{1-x}$, the same range of x is of interest. However, if layer 10 is composed of $In_{1-x}Al_xSb$, x is less than about 0.06 and typically $x < 0.04$. The sheet resistance, $R_s$, measured in ohms per square, is given by $R_s = (qtun + qtUp)^{-1}$ where q is the electron charge (1.602 x $10^{-19}$ coulombs), u-(U) is the electron (hole) mobility (in $cm^2V^{-1}s^{-1}$), n (p) is the electron (hole) density or concentration ($cm^{-3}$) and t is the active layer thickness (cm). Thus, for example, if n = 1 x $10^{17}cm^{-3}$, u = 30,000 $cm^2V^{-1}s^{-1}$, and t = 0.5 micrometers, and un >> Up, then $R_s$ = 40 ohms per square. Thus, if the length and width of a rectangular section of active region are equal (i.e., it is square), the resistance from one edge to the opposite edge of the square section would be 40 ohms. Furthermore, for given values of u and n, the sheet resistance of a thin layer with t < 0.5 micrometers is several times larger than that of a thick layer which may be of the order of 2 micrometers thick. With this thinner layer, it is then possible to make a series-connected number of magnetoresistors with a given total resistance with a smaller number of elements which cover a smaller area than would be the case with a thicker film. Note that these elements are generally not square, but are usually rectangular with lengths less than their widths. An important requirement of the buffer layer 12 is that its sheet resistance be at least about 10 times, and preferably at least 30 times, that of the active layer 10. This may be accomplished by making the energy band gap of layer 12 large enough that the intrinsic carrier density is significantly reduced below that of InSb, e.g., to less than 1 x $10^{16}$ $cm^{-3}$ at the maximum operating temperature. Furthermore, layer 12 may be doped lightly p-type, e.g., to 2 x $10^{16}$ $cm^{-3}$, reducing its electron concentration to a low value. Since the hole mobility U in layer 12 is < 500 $cm^2V^{-1}s^{-1}$, the sheet resistance of layer 12 may be as high as 3000 ohms per square, depending upon the mobility of the residual electrons, and assuming that the thickness of layer 12 is two micrometers. Thus, while it is an important object of this invention to make the sheet resistance of layer 10 large, it must not be made so large that it becomes comparable to that of layer 12. This is because the low mobility electrons or holes in layer 12 would degrade device sensitivity. This is an additional constraint on the thickness of layer 10. Note that, in the sample calculation of sheet resistance of layer 12 just cited, the film is doped substantially p-type. It is preferable for the hole concentration in layer 12 to be reduced to a much lower value, such as 2 x $10^{15}$ $cm^{-3}$ or less, if this can be done without creating a density of electrons in layer 12 which is large enough to dominate its sheet resistance. As an example, for automotive applications, the maximum operating temperature is typically in the range of 70°C to 200°C. Since the intrinsic carrier density increases with temperature, higher operating temperatures make it more difficult to make the sheet resistance of layer 12 remain about a factor of 10 or more larger than that of layer 10. The minimum required operating temperature for automotive applications is typically -40°C, and this is not normally a problem. Other nonautomotive applications for magnetic field sensors would, in general, have somewhat different maximum and minimum operating temperatures.

Other features and advantages of this invention will become more apparent from the following description of preferred embodiments thereof and from the drawings.

Brief Description of the Drawings

The present invention will now be described, by way of example, with reference to the accompanying drawings, in which:

Figure 1 shows a diagrammatic sectional view of a magnetoresistor made in accordance with this invention;

Figure 2 shows a diagrammatic sectional view of an alternative magnetoresistor structure made in accordance with this invention;

Figure 3A shows a diagrammatic plan view of an integrated magnetoresistor sensor of given resistance and sensitivity made in accordance with the prior art;

Figure 3B shows a diagrammatic plan view of an integrated magnetoresistor sensor of the given resistance and sensitivity but made in accordance with this invention;

Figure 4 shows a diagram in which lattice constant of various semiconductor materials is plotted against energy band gap; and

Figure 5 shows a diagrammatic sectional view of another alternative magnetoresistor structure made in accordance with this invention.

Description of an Embodiment of the Invention

Reference is now made to Figure 1, which shows a magnetoresistor that comprises a rectangular monocrystalline indium gallium antimonide mesa layer 10 that is epitaxially deposited on layer 12. Layer 12 is a monocrystalline layer of a compound semiconductor that is of the same crystal structure as layer 10 and that is substantially lattice matched. However, the compound semiconductor material of layer 12 is generally of a higher energy band gap semiconductor material than layer 10. Layer 12, for example, can be of indium aluminum antimonide, or of indium gallium antimonide which may have a higher gallium content than layer 10. By the same crystal structure, it is meant that the materials both have a crystal lattice type that is zinc blende. By substantially lattice matched, it is meant that the materials forming layers 10 and 12 have stress-free lattice constants that are at least within about 0.07 angstroms of one another, and preferably within about 0.01 angstroms of one another. This residual lattice mismatch is at least partially and preferably totally accommodated by tensile and/or compressive strain in layers 10 and 12. Thus, few or preferably no additional dislocations are created in layer 10 beyond the threading dislocations which propagate upward from the top surface of layer 12 into layer 10. For a given mismatch of stress-free lattice constants of layers 12 and 10, as the thickness of layer 10 is increased, the compressive stress in it builds up until a critical thickness, h, is reached, at which thickness the strain energy is so great that the system can reduce its total energy by forming crystallographic defects such as dislocations or microcracks. Note that this does not imply that all of the strain is then abruptly relieved by formation of defects. Rather, it often happens that defects are gradually introduced as the film is grown thicker, so that the defect density gradually increases. Thus, useful films may be grown with thicknesses greater than h. There have been attempts to model h as a function of lattice mismatch and other material parameters for various materials systems. All models agree that larger lattice mismatch leads to smaller critical thicknesses. However, even if the thickness of layer 10 is below h, the electron effective mass in layer 10 may be increased by lattice strain, which may degrade electron mobility and hence device sensitivity. However, if the thickness of layer 10 is made too small, surface depletion effects become significant, and quantum confinement effects become important, which increase the electron effective mass and therefore decrease the sensitivity of the sensor to magnetic fields. Since the sheet resistance also varies with the thickness of layer 10, there are tradeoffs to consider in choosing this thickness which depend upon the materials composition, doping level, defect density, strain, device layout, sensor operating temperature range, and required total resistance, power consumption and sensitivity.

It appears that the Fermi energy in InSb is pinned near its valence band edge at the surface of InSb. This is probably true of its dilute alloys as well, such as InSb-rich InGaSb, InAlSb and InAsSb. This means that layer 10 will be depleted of electrons near its top surface (Figure 1) for a depletion width or distance which increases as the inverse square root of doping density. At the lowest doping levels contemplated in this invention of about $3 \times 10^{16}$ cm$^{-3}$ for layer 10, this leads to a depletion depth of about 0.1 micrometer, which is a substantial fraction of even the maximum preferred thickness of layer 10. Doping density can be increased to offset this effect. A preferred approach is to heavily dope a very thin layer at the top of layer 10 as disclosed in U.S. Patent No. 5,153,557, entitled Magnetic Field Sensor Contacts, by D. L. Partin and J. P. Heremans, since this also facilitates formation of low resistance ohmic contacts. For example, if this thin layer is doped at $1 \times 10^{18}$ cm$^{-3}$, it will be fully depleted if its thickness is about 180 angstroms. However, it is generally desirable to make the thickness of this "contact layer" somewhat greater, typically in the range of 200 to 500 angstroms if the dopant density is about $1 \times 10^{18}$ cm$^{-3}$. This is because a portion of this surface layer is converted to oxide upon exposure to air, or may be chemically etched away upon exposure to acids or other chemicals used to prepare the surface for the deposition of ohmic contact in some regions of the sensor structure. These ohmic contacts may serve as "shorting bars" or as end contacts to which leads may be bonded for ohmic contacts. Some of the contact layer may also be consumed by chemical reaction with ohmic contact materials. Thus, this contact layer enhances ohmic contacts (decreases their resistance) where it is under such contacts, and serves the additional purpose in other regions of preventing surface depletion effects from removing a large number of electrons from the thin active layer. It may be partly etched away in these non-contact regions so that it is not so thick that it contributes high density, low mobility electrons to the active layer.

All of the alloys of InSb referred to in this invention may be conventional "random" alloys in which Al or Ga atoms are randomly substituted for In atoms on the In sub-lattice of InSb or As atoms randomly substitute for Sb atoms on the Sb sub-lattice. However, these alloys may also be non-random pseudoalloys, which are also commonly referred to as digital alloys or short period superlattices. In these alloys, layers of two materials are alternately grown on such a small distance or thickness scale that they act like alloys more than like two dissimilar materials. The repeat distance or periodicity is in the range of about 10 to 200 angstroms. For example, an $In_{1-x}Ga_xSb$ alloy may be composed of alternating layers of GaSb and InSb, in which one or two monolayers of GaSb are alternated with many monolayers of InSb. A variant would be for a few monolayers of $In_{1-y}Ga_ySb$ to be alternated with many layers of InSb. In either case, the concentration of GaSb may be very large within a layer, but the average GaSb concentration, averaged over one or more periods, is less than about 20%, as previously specified. Use of these digital alloys is somewhat more difficult from a growth point of view, but can be advantageous, e.g., in producing an active layer 10 with higher electron mobility. It is noted that $In_{1-x}Al_xSb/InSb$ superlattices have been reported without any transport data. (See, for example, V. P. Gnezdilov, D. J. Lockwood and J. B. Webb, Physical Review B, Vol. 48, p. 8442 (1993)).

The substantially lattice matched but typically higher energy band gap compound semiconductor material of layer 12 is a monocrystalline material that was epitaxially deposited onto a monocrystalline wafer 14. Wafer 14 is of a monocrystalline semiconductor material having the same or related crystal structure as the semiconductor material of layers 10 and 12. However, it also has an energy band gap of at least about 0.66 eV (for example, silicon or germanium, which have the diamond crystal structure), and preferably about 1.3eV (for example, gallium arsenide and indium phosphide, both of which have the zinc blende crystal structure). In addition, wafer 14 should have a lattice constant of at least about 5.4 angstroms (for example, silicon or gallium phosphide). Preferably, it would have a lattice constant of at least about 5.65 (for example, germanium or gallium arsenide), and even more preferably at least about 5.9 (for example, indium phosphide). Also, layer 12 and wafer 14 do not each have to be homogeneous. Either can be layered, as hereinafter described.

As will become more apparent, layer 12 functions as a special buffer layer between wafer 14 and active layer 10. This permits the usual or less expensive substrates to be used that are not highly lattice matched. However, a high mobility indium gallium antimonide layer can still be grown in thicknesses of less than about 0.5 micrometer. By way of further example, wafer 14 can even be a monocrystalline ternary compound semiconductor such as indium gallium arsenide. Still further, it could be a composite substrate such as silicon or germanium having an epitaxial gallium arsenide surface layer thereon, upon which layers 10 and 12 of this invention can be deposited. Accordingly, where reference is made to a substrate wafer for use in this invention, it is meant to include not only homogeneous substrate wafers but also substrate wafers that have one or more layers thereon that make them useful, and particularly more useful, in this invention. This would include a compound semiconductor layer on elemental semiconductors, such as a gallium arsenide layer on a germanium wafer or on a silicon-on-insulator (SOI) silicon wafer: However, it would also include one or more compound semiconductor layers on a compound semiconductor wafer, as for example surface layers on a gallium arsenide wafer or indium phosphide wafer.

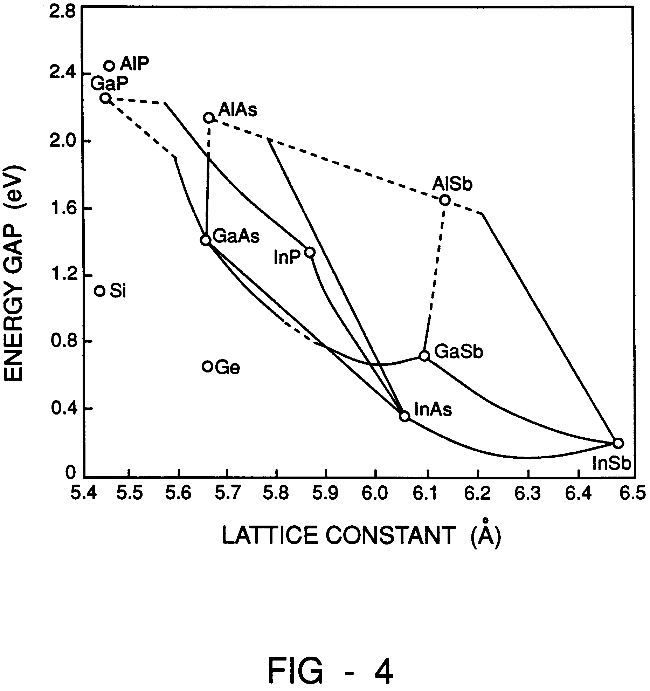

In this latter connection, one might alternatively choose to substitute a ternary compound semiconductor, such as aluminum gallium arsenide, for the binary compound semiconductor (gallium arsenide) layer on the silicon or germanium wafer. In such instance, the layer on the surface of the silicon or germanium wafer would have a larger energy band gap than gallium arsenide as shown in Figure 4. Hence, it has a lower intrinsic conductivity. As indicated above, this is desirable. In order to further increase the resistivity of the aluminum gallium arsenide layer, one could dope it with a deep level impurity such as oxygen, iron, chromium, or the like. The result would be a composite wafer of reasonably high resistivity, and closer matching in lattice constant to indium gallium antimonide than is silicon. Such a substrate wafer may be desired, for example, where reducing the cost of the substrate wafer is of great concern. Other intermediate layers, including a thin film of monocrystalline silicon on top of an insulating silicon oxide layer on top of a monocrystalline silicon substrate are also suitable. The oxide layer prevents current from flowing into the thick silicon substrate, which has a relatively low sheet resistance because of its thickness. Therefore, the buffer layer of the present invention may be grown directly upon the thin silicon film.

It is recognized that difficulties may be encountered in actually nucleating epitaxial deposition of some of the materials mentioned above onto a given surface. This may be particularly true for deposition of layer 12, if wafer 14 is a composite containing aluminum. For example, an aluminum-containing ternary or quaternary compound semiconductor material could have been used to form a surface layer on a composite wafer or substrate 14. In such instance, an extremely thin nucleation layer (not shown) can initially be deposited onto the deposition surface of the composite wafer 14. The nucleation layer (not shown) might be an extremely thin layer of indium antimonide, gallium antimonide, aluminum gallium antimonide or indium gallium antimonide.

As indicated above, it is contemplated that layer 10 be of a thickness of about 0.5 micrometer or less. The actual thickness of layer 10 that is needed will be a matter of design choice. However, one factor to consider is the actual difference in lattice constant between layers 10 and 12, as previously discussed. Another is the crystal quality of the surface of layer 12 upon which layer 10 is to be deposited. The lower the deposition surface quality, the thicker the indium gallium antimonide has to be grown to get a high average crystal quality and its desired attendant high electron mobility. Such a layer provides mobilities typically in excess of 30,000 $cm^2V^{-1}s^{-1}$. This is considered to be a high mobility at this time.

As indicated above, the crystal quality of the surface of layer 12 affects layer 10. It is therefore preferred to make the quality of the surface of layer 12 as high as is practical. To do that, of course, requires that the surface of wafer 14 be of high quality. However, in this invention, it is preferable to obtain an observance of lattice constant and energy band gap. If epitaxial growth is initially of reasonable quality, the thicker one grows the layer, the more likely one can improve crystalline quality. It should also be noted that in this invention, layer 12 is formed of a material having a lower resistivity than wafer 14. Accordingly, layer 12 should be as thin as is practical, to maximize sensor resistance parallel to active layer 10. On the other hand, the bigger the difference in lattice constant between layer 12 and wafer 14, and/or the poorer the crystal quality of the surface of wafer 14, the thicker layer 12 has to be. In general, with the usual quality commercially available for gallium arsenide wafers, a high quality surface can be obtained on layer 12 if it is about 1 to 2 micrometers thick. In some instances, sufficient quality may be obtained if layer 12 is only 0.5 micrometer thick. In any event, once layer 12 has sufficient thickness to produce a high quality crystal surface on it, any additional thickness is objectionable because it reduces the sheet resistance of layer 12. Further, it should be recognized that smaller thicknesses can be used for layer 12, especially if wafer 14 is a composite wafer having a thin, high crystal quality surface layer more closely matching the lattice constant of layer 12 than gallium arsenide. In any event, layer 12 should be of a thickness of at least about 0.1 micrometer. The epitaxial layers 10 and 12, and any surface layers desired in a composite wafer 14, and the nucleating layers, can be deposited by any convenient technique. They can be produced by at least one of a variety of growth techniques, including molecular beam epitaxy (MBE), metal organic chemical vapor deposition (MOCVD), vapor phase epitaxy (VPE), liquid phase epitaxy (LPE), metal organic magnetron sputtering, and still other deposition techniques. The particular substrate and layer compositions chosen may determine which of the growth processes is optimal for that particular combination. For example, it is characteristic of VPE that it is difficult to introduce aluminum into the growth layer. On the other hand, if deposition is difficult, one may choose to initially grow a thin nucleating layer of a material compatible with the semiconductor system and which deposits satisfactorily in the deposition process used.

As indicated above, layer 12 should have a higher energy band gap than layer 10 but still be substantially lattice matched. It can be seen in connection with Figure 4 that aluminum antimonide and gallium antimonide have a generally similar lattice constant. However, aluminum antimonide has a significantly higher energy band gap. Hence, aluminum antimonide inherently has a much higher intrinsic resistivity at room temperature than either indium antimonide or gallium antimonide. This invention recognizes that even small additions of aluminum to indium antimonide can significantly increase the energy band gap of indium antimonide. This invention further recognizes that such small additions do not change the lattice constant of indium antimonide very much. Still further, this invention recognizes that small additions of gallium to indium antimonide do not decrease electron mobility very much. In addition, this invention also recognizes that generally equivalent small additions of gallium or aluminum (to indium antimonide) provide a lattice constant that is about equal. More precisely, $In_{1-y}Al_ySb$ is lattice matched to $In_{1-x}Ga_xSb$ if y = 1.12x. Such recognitions are utilized in the distinctive layered structure shown in Figure 1.

The concept of using a composite wafer material to form substrate 14 is shown in Figure 2. Figure 2 shows a magnetic field sensor that is made on an elemental semiconductor wafer 14a, such as of silicon or germanium, and covering it with a layer 14b of higher energy band gap material, to form a composite wafer 14. Wafer surface layer 14b is of gallium arsenide (GaAs). Buffer layer 12 is similar to layer 12 in Figure 1. Thus, it need not be described again here. Active layer 10 is the same as active layer 10 in Figure 1. Accordingly, it shall not be further described again. The right and left opposite edges of the rectangular mesa 10 have metal electrodes 16 and 18 formed thereon. The dimensions of the rectangular area of layer 10 ordinarily are a subject of design compromise. However, generally speaking, the length of rectangular sides under electrodes 16 and 18 are generally longer than the other two sides of the rectangular area 10. Some of the principles involving dimensions of such rectangular areas and for methods of forming a plurality of serially connected but integrated areas of this type are described in United States Patent 4,926,154, whose inventors include the inventor named in this patent application. That disclosure is incorporated herein by reference. In substance, U.S. Patent 4,926,154 discloses forming a magnetically active blanket semiconductor layer on a substrate photolithographically delineating that layer into a mesa on the substrate and then metallizing the mesa. The mesa is metallized by blanket depositing an appropriate metal coating, as for example gold or gold-germanium alloy, on the entire surface of the mesa and the wafer, and then photolithographically delineating terminals on the mesa ends. U.S. Patent 4,926,154 further describes forming an integrated serially-connected multiplicity of rectangular areas by simply forming transverse "shorting bars" that extend across the mesa. All of the foregoing is also applicable to Figure 1.

In order to obtain a high sensor resistance, it has been the practice to use an elongated mesa, in which many rectangular sensing units are serially integrated. In order to obtain the maximum length of mesa in a given unit area, it is usually made in a "U-shape" or in a sinuous shape, frequently both. Such a sinuous "U-shape" is shown in Figure 3A.

Both the plan view and the compositions of Figure 3A are representative of the prior art. For example, Figure 3A shows a rectangular monocrystalline gallium arsenide or indium phosphide wafer 14, on which are disposed six discrete linear and parallel mesas 10a, 10b, 10c, 10d, 10e, and 10f. Mesas 10a through 10f are of thin films of indium antimonide (InSb) that is doped n-type to generally stabilize its conductivity against change with temperature change. Each of the mesas 10a through 10f has a plurality of shorting bars 20 on its surface, with opposite ends of each shorting bar overlapping onto the adjacent surface of wafer 14. The shorting bars 20 divide each elongated mesa into a plurality of successive serially-connected, integral rectangular magnetically sensitive areas.

The lower end of mesa 10a is overlapped by metal electrode 16. The lower end of mesa 10f is overlapped by metal electrode 18. The upper ends of mesas 10a and 10b are overlapped by enlarged metal shorting bar 20a. The upper ends of mesas 10c and 10d are overlapped by enlarged metal shorting bar 20b. The upper ends of mesas 10e and 10f are overlapped by enlarged metal shorting bar 20c. The lower ends of the shorter mesas 10b and 10c are overlapped by a lower metal enlarged shorting bar 20d. Analogously, the lower ends of the shorter mesas 10d and 10e are overlapped by the lower enlarged metal shorting bar 20e.

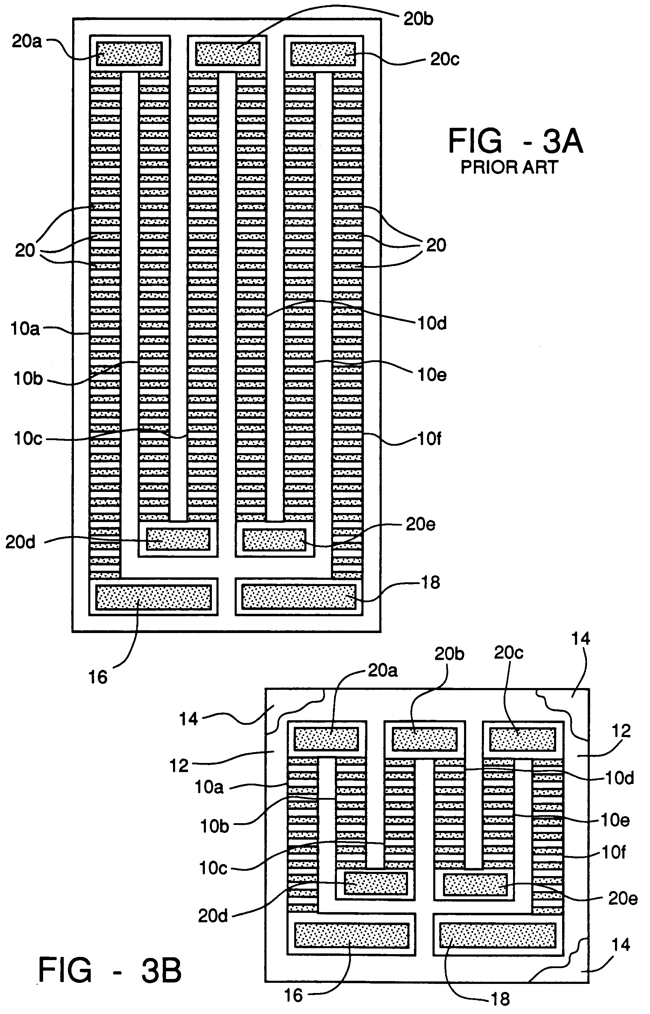

Figure 3B shows a rectangular monocrystalline gallium arsenide or indium phosphide wafer 14 having a blanket monocrystalline surface layer 12 thereon of $Al_yIn_{1-y}Sb$ where "y" is as hereinafter described. Disposed on blanket layer 12 are monocrystalline thin film mesas 10a through 10f of $Ga_xIn_{1-x}Sb$ where "x" is as hereinafter described. Figure 3B shows mesas 10a through 10f as being decidedly shorter than mesas 10a through 10f of Figure 3A.

Mesas 10a through 10f of Figure 3B are only one-third to one-quarter of the length (or number) of mesas 10a through 10f in Figure 3A. The reason for this is that the Figure 3B magnetoresistor is made in accordance with this invention. In Figure 3B, mesas 10a through 10f have a thickness of only up to about 0.5 micrometer. The mesas 10a through 10f in Figure 3A have a thickness of about 2 to 5 micrometers. The significant layer thickness reduction in Figure 3B permits one to reduce the length of the mesas (over the length in Figure 3A) and still obtain the same or even higher resistance between terminals 16 and 18. This comparison in Figures 3A and 3B is shown to illustrate that reduced power consumption is not the only benefit achievable in this invention. One can also use the principles of this invention to make a smaller sensor. The smaller sensor permits a higher spatial resolution to be obtainable with a sensor of the same or even higher total sensor resistance. The result is a higher spatial resolution sensor of the same or lower power consumption.

Reference is again made to Figure 4. More specifically, it can be seen from Figure 4 that none of the compound semiconductors listed have lattice constants as large as that of indium antimonide. On the other hand, it can also be seen that $Al_y In_{1-y} Sb$ can be lattice-matched to $Ga_y In_{1-y} Sb$. It can also be seen that $Al_y In_{1-y} Sb$ has an energy band gap that rises very rapidly with increasing values of "y". Accordingly, semiconductor material with moderate values of "y", for example, where "y" = about 0.1-0.2, has an energy band gap significantly higher than that of InSb. This makes $Al_y In_{1-y} Sb$ have a higher intrinsic resistivity than that of InSb. Alternatively, $Al_y In_{1-y} Sb$ may be doped very lightly p-type to increase its resistivity (instead of or in addition to doping it with a deep impurity), since holes have a much a lower mobility (than electrons) in an indium antimonide-rich composition.

In further specificity, layer 10 is an epitaxially deposited monocrystalline layer of $Ga_x In_{1-x} Sb$ where "x" is preferably less than 0.2. More importantly, it is preferred that "x" in $Ga_x In_{1-x} Sb$ be about equal to "y" in $Al_y In_{1-y} Sb$. More precisely, lattice matching is attained if y = 1.12x. The reason for this is that at small values of "x" and "y", the lattice constants of the compound semiconductors $Ga_x In_{1-x} Sb$ and $Al_y In_{1-y} Sb$ are about the same. In such instance, layer 10 has a very high electron mobility, even though it is less than about 0.5 micrometer thick. The reason is that layer 10 is substantially lattice matched to layer 12, which provides maximum available electron mobility in such small thicknesses.

The electron mobility decreases for $Ga_x In_{1-x} Sb$ as "x" increases due to alloy-disorder scattering. However, when "x" is approximately 0.2 or less, the resultant electron mobility in layer 10 is not too greatly degraded from that of InSb on a gallium arsenide substrate. There may be exceptional circumstances where one may choose to use a value of "x" in $Ga_x In_{1-x} Sb$ that is in excess of 0.2. However, it is doubtful that one would choose to use a value of "x" that is greater than 0.3, because such materials have relatively low electron mobility. It is desirable to make x in $Ga_x In_x Sb$ as small as possible to minimize alloy disorder scattering, and so x < 0.1 is most preferable.

In the examples described so far of this invention, it is preferred that 1.12 times x in $Ga_x In_{1-x} Sb$ equal "y" in $Al_y In_{1-y} Sb$, for values of "x" and "y" of 0.2 or less. The reason for this is that at such low values of "x" and "y", very close lattice matching can be achieved, which minimizes dislocation density in initially deposited portions of layer 10. Furthermore, alloy disorder scattering in layer 10 is minimized as the gallium concentration ("x") is minimized. This, of course, provides highest electron mobility in the smallest thickness. This, in turn, provides maximum magnetic sensitivity in the smallest thickness of the active layer. As indicated above, this leads to highest sheet resistances in the active layer and benefits of it identified above.

It should also be mentioned that in some instances, raising the energy band gap of layer 12 may be more important than getting it to very closely match the lattice constant of active layer 10. In such an instance, one may choose to use a substantially higher value of "y" in $Al_y In_{1-y} Sb$ than "x" in $Ga_x In_{1-x} Sb$. One could additionally dope the $Al_y In_{1-y} Sb$ layer to make it additionally nonconductive. These techniques could be used to produce a magnetoresistor in accordance with this invention in which minimized power consumption is more important than maximized magnetic sensitivity.

Accordingly, this invention provides an opportunity for obtaining much greater lattice-matching than heretofore achievable and, therefore, the opportunity to make extremely thin films of very high electron mobility. Generally speaking, the values of "y" and "x" in $Ga_x In_{1-x} Sb$ and $Al_y In_{1-y} Sb$ should be such that y differs from 1.12 x by no more than about 0.2, preferably by not more than 0.1 and most preferably by not more than 0.02. This permits one to obtain a fairly close lattice match, and thereby obtain relatively high electron mobilities within layer thicknesses of about 0.5 micron or less. As a rule of thumb, layer 10 will have a mobility of at least about 30,000 $cm^2 V^{-1} S^{-1}$ in thicknesses of only 0.1 to 0.5 micrometer, when layer 10 is $Ga_x In_{1-x} Sb$ and layer 12 is $Al_y In_{1-y} Sb$, with "x" being less than 0.05 and $| y - 1.12 x | <$ 0.1. For lowest microcrack density, however, it is preferred that $| y - 1.12 x | <$ 0.03.

Very close matching of the lattice constants (i.e., $| y - 1.12 x | <$ 0.03) provides still another benefit in electron mobility. However, this only occurs for films having a thickness of about 400 to 2000 angstroms or less, which is referred to herein as a critical thickness. If the lattice constants of layers 10 and 12 are within 0.1% of one another, i.e., differ less than about 0.06 angstrom, and the thickness of active layer 10 is within the critical thickness, layer 10 will exhibit a unique effect. Active layer 10 will exactly adopt the same lattice structure as the surface on which layer 10 is grown. Accordingly, within this critical thickness, layer 10 will have no added dislocations as a result of lattice mismatch. This means that the overlying layer faithfully reproduces the surface on which the layer is grown. In other words, it is just as high in crystal quality as the crystal surface on which it is grown. Such a film will have maximum mobility, rivaling the mobility obtained only in the upper portions of much thicker layers. In addition, because it is so thin, it will have a very high sheet resistance. Thus, an extremely low power consumption magnetoresistor can be made with high sensitivity, if layers 10 and 12 are very closely lattice matched and active layer 10 is only about 400 to 1500 angstroms thick. This also permits one to make a much smaller sensor of a given total sensor resistance, which affords the added benefit of higher spatial resolution.

Still further, it should be recognized that within the critical thickness of about 400 to 1500 angstroms referred to in the preceding paragraph, electrons move within layer 10 in ballistic trajectories over relatively large distances. This tendency to ballistic movement can be exploited. Where close lattice matching between layers 10 and 12 is used and layer 10 is about 400 to 1500 angstroms thick, layer 10 can be the thin active layer contemplated in U.S. Patent 5,038,131 to Olk et al, the disclosure of which is incorporated herein by reference. The Olk et al patent involves a magnetoresistor having a thin film of degenerately doped semiconductor material extending between conductive contacts to the film. The film and contacts are similar in concept to active layer 10 and contacts 16 and 18 in Figure 1 hereof. The film has a plurality of parallel rows of staggered miniature openings therethrough. The staggered openings provide openings in any given row being between two openings in the adjacent rows. The openings are selected to be of a size such that when a magnetic field is applied perpendicular to the major surface of the film, the magnetic field causes electrons flowing through the film (between electrodes 16 and 18) to flow in a series of substantially arcuate or circular paths around said openings. This effect provides an increase in length an electron has to travel between electrodes 16 and 18, even though the electron travels substantially ballistically at high mobility. Hence, film electrical resistance between the contacts 16 and 18 increases, which increases magnetic sensitivity. An added important feature of this enhanced magnetic sensitivity (i.e., resistivity) is that it has a lower temperature coefficient than is available for magneto diodes or magnetoresistors whose magnetic sensitivity is merely a function of ordinary electron mobility. Whereas this Olk et al patent has ordered arrays of openings in the active layer, it is believed that a substantially large effect can still be obtained from randomly or semi-randomly located submicron openings in layer 10. Furthermore, while this Olk et al patent concerns a two terminal device, a four terminal Hall effect device could be equally well made from such a film. It should be noted that ballistic transport can be attained, although over shorter distances, in the case where the critical thickness of layer 10 is exceeded.

As previously mentioned, in some cases raising the energy band gap of layer 12 may be more important than getting it to very closely match the lattice constant of active layer 10. In such a case, one might grow $In_{1-y}Al_ySb$ for layer 12 and

$In_{1-x}Al_xSb$ for layer 10, where y ≥ x. Here, "y" is less than about 0.3, and preferably less than 0.15, and "x" is in the range 0.06 > x ≥ 0, and preferably in the range the range 0.04 > x ≥ 0. The interface between layer 12 and layer 10 may be abrupt or may be graded.

As mentioned, in the past the relatively low energy band gap of pure InSb has produced such a large temperature sensitive base conductivity that it had to be stabilized by n-type doping. Certainly active layer 10 does not escape this problem. However, it can be solved the same way, i.e., by n-type doping. As to buffer layer 12, it may or may not also require stabilization, depending upon its specific composition. As indicated, buffer layer 12 can alternatively be doped to simply make it less conductive. Accordingly, layers 10 and 12 can be stabilized with respect to temperature, or layer 12 can be doped to make it more nonconductive, in the normal accepted way for such compound semiconductor materials.

However, in addition, since the layers are so thin, it is possible to alternatively stabilize them by modulation doping. By modulation doping, it is meant that the dopant species for layer 10 is placed in the underlying $Al_yIn_{1-y}Sb$ of layer 12. Electrons will transfer to the lower energy band gap $Ga_xIn_{1-x}Sb$ material of layer 10 to stabilize the electron concentration of layer 10 without reducing electron mobility as much as it would be reduced if the electrons were from positively charged donors located directly in layer 10. An additional magnetic field sensor structure is shown in Figure 5. This structure is similar to that of Figure 1, except that an additional layer 19 is added on top of layer 10 and the top surface of layer 10 is not heavily doped to avoid depletion effects. Layer 19 is a III-V compound semiconductor with the zinc blende crystal structure and an energy band gap which is larger than that of layer 10. It may have the same composition as layer 12 (e.g., $In_{1-y}Al_ySb$) or it may be an even higher band gap semiconductor which is not even close to being lattice matched to the active layer 10, such as GaSb or $In_{1-y}Ga_ySb$ with a relatively large value of y (e.g., y > 0.3). Layer 19 is thin (e.g., 300 to 1000 angstroms) and is doped n-type. Electrons then transfer to the lower bandgap material of layer 10, modulation doping from layer 12, as previously discussed, in order to maximize the electron density in layer 10.

Still further, one may choose to form layer 12 as a plurality of alternating film compositions. In this latter connection, the alternating films of layer 12 would be about 50 to 100 angstroms thick. Repetition of such a sequence in a total number of layers of about 20 or more could form a superlattice and help relieve strain due to lattice mismatch with wafer 14. In such instance, layer 12 might end up with a lower total thickness even though its average lattice constant was closer to that of layer 10 than to that of the substrate wafer 14. A superlattice in layer 12 formed of alternating films of $Al_yIn_{1-y}Sb$ and $Al_zIn_{1-z}Sb$ could be used as a dislocation filter, allowing layer 12 to be a much thinner buffer layer and of higher crystal quality. The higher crystal quality that the surface of layer 12 is, the higher the average quality layer 10 can be within a smaller thickness. Accordingly, the higher its mobility and attendant magnetic sensitivity will be in a smaller thickness. Layer 12 could be formed partly of random alloy and partly of a superlattice.

The foregoing discussion has focused on $Al_yIn_{1-y}Sb$ being the higher energy band gap material and $Ga_xIn_{1-x}Sb$ being the high mobility material. However, several variations on the foregoing based on these and other ternary alloys may be useful. For example, $InAs_xSb_{1-x}$ could be used instead of $Ga_xIn_{1-x}Sb$ for active layer 10 and lattice matched to an $Al_yIn_{1-y}Sb$ buffer layer 12. However, as shown in Figure 4, the energy band gap of $InAs_xSb_{1-x}$ is smaller than that of $Ga_xIn_{1-x}Sb$ for a given value of lattice constant. This means that the intrinsic electron density of $InAs_xSb_{1-x}$ is higher. This is undesirable, since it means that $InAs_xSb_{1-x}$ must be doped more heavily n-type than InSb to stabilize its electron density, which reduces the electron mobility of $InAs_xSb_{1-x}$. This provides a lower, although still useful, magnetic sensitivity than an active layer of $Ga_xIn_{1-x}Sb$. Further, active layer 10 could alternatively be made of $InP_xSb_{1-x}$. However, it suffers from problems similar to those for active layers formed of an $InAs_xSb_{1-x}$ material. Accordingly, at this time an active layer of $Ga_xIn_{1-x}Sb$ is preferred for conventional magnetoresistors. However, for $InAs_xSb_{1-x}$ or $InP_xSb_{1-x}$ compositions of layer 10 in which "x" is sufficiently small, e.g., x < 0.1, the decrease in energy band gap is small. In this limit, $InAs_xSb_{1-x}$ and $InP_xSb_{1-x}$ are useful materials for layer 10. Moreover, for structures involving the Olk et al patent previously referred to, the active layer 10 must be doped rather heavily n-type. This is because there will be surface depletion effects around the openings in layer 10 which can make the "electrical diameter" of the circular openings much larger than the physical diameter. That is, the electrons will have to travel around the physical diameter plus twice the depletion distance. It is desirable to minimize this depletion distance by increasing the electron concentration of layer 10, either by doping it directly or by modulation doping it from layer 12 and/or layer 19. Since large electron densities (e.g., $3 \times 10^{18}$ $cm^{-3}$) are required to minimize depletion effects, there is no disadvantage to using $InAS_xSb_{1-x}$ for layer 10. This is lattice-matched to $In_{1-x}Al_ySb$ in

layer 12 if y = 1.23x. Note that the use of these large electron densities decreased the sheet resistance of layer 10.

While the $Al_yIn_{1-y}Sb$ material has a higher energy band gap and is preferred, it is recognized that there may be cases where it is necessary to exclude aluminum because of limitations in growth technology. It is recognized that inclusion of aluminum into ternary alloys by some workers and by some equipment may not be possible. In such instance, one may choose to use an alternative material for each of layers 10 and 12. For example, layer 12 could be a layer of $Ga_xIn_{1-x}Sb$, and active layer 10 could be of $InAs_ySb_{1-y}$ or $InP_ySb_{1-y}$. However, as indicated above, highest magnetic sensitivities and/or lowest power consumption is not realized.

Layers 10 and 12 are shown as discrete layers. However, the composition of layer 12 could be graded in its upper portions to gradually substitute gallium for aluminum. In such instance, the change in composition from layer 12 to layer 10 would be gradual, with the gallium content gradually increasing between the layers and aluminum content gradually decreasing. It should also be recognized that enhanced magnetic sensitivity may be obtained if the initially deposited portion 10' of layer 10 (shown in Figure 1) is intrinsic, i.e., not doped n-type.

Layers 10 and 12 of the sensor have been described in connection with compound semiconductors that are ternary alloys. One can follow the principles of this invention and grow a buffer layer 12 of a quaternary alloy, such as $Al_xIn_{1-x}As_ySb_{1-y}$. In such instance, one could for example choose the active layer 10 to be a quaternary alloy such as $Al_xIn_{1-x}As_ySb_{1-y}$ of a lesser aluminum and/greater arsenic content. This would produce higher mobility for layer 10 but with a lower energy band gap.

The foregoing description shows that the preferred embodiments of the present invention are well suited to fulfill the objects above stated. The foregoing detailed description recognizes that those skilled in the art may make various modifications or additions to the preferred embodiments described herein without departing from the spirit and proper scope of the invention.

## Claims

1. A magnetic field sensor comprising:

   a substrate (14) having a monocrystalline and at least semi-insulating surface region, said substrate surface being of a material of a compatible crystal type with indium antimonide and having a lattice constant of at least about 5.4 angstroms;

   a first epitaxial layer (12) disposed on said substrate surface of a first compound semiconductor material of compatible crystal type, said layer having a high crystal quality outer surface, said first compound semiconductor material having a lattice constant of at least about 6.3 angstroms and having a given energy band gap and electron mobility;

a second epitaxial layer (10) disposed on said high quality crystalline outer surface of said first epitaxial layer, said second epitaxial layer being of a second compound semiconductor material of compatible crystal type, said second compound semiconductor material having a lattice constant closely matching that of said first compound semiconductor material but having a lower energy band gap and a higher electron mobility;

said second epitaxial layer (10) being an elongated mesa on said first epitaxial layer (12) and having a thickness not substantially greater than about 0.5 micrometer; and

electrical contacts (16, 18) to opposite ends of said mesa;

effective to provide a magnetic field sensor having a magnetically active layer of not only high electron mobility but also of high sheet resistance, which affords lower power consumption per unit sensor area, smaller sensor area and higher spatial resolution in sensing.

2. The magnetic field sensor as defined in claim 1 wherein the first and second compound semiconductor materials are selected from the group consisting of ternary and quaternary alloys of indium antimonide.

3. The magnetic field sensor as defined in claim 2 wherein the first compound semiconductor material is indium aluminum antimonide and the second compound semiconductor material is indium gallium antimonide or indium arsenide antimonide or indium aluminum antimonide.

4. The magnetic field sensor as defined in claim 1 wherein the first epitaxial layer is at least about 0.5 micrometer thick, the first compound semiconductor material is $Al_yIn_{1-y}Sb$ where "y" is less than about 0.3, the second epitaxial layer is less than about 0.5 micrometer thick, and the second compound semiconductor material is $Ga_xIn_{1-x}Sb$ where "x" is less than about 0.3.

5. The magnetic field sensor as defined in claim 1 wherein the magnetic field sensor is a magnetoresistor, the first epitaxial layer is at least about 0.5 to 2.0 micrometer thick, the first compound semiconductor material is $Al_yIn_{1-y}Sb$, where "y" is less than about 0.2, the second epitaxial layer is less than about 0.5 micrometer thick, and the second compound semiconductor material is $Ga_xIn_{1-x}Sb$, where "x" is less than about 0.2.

6. The magnetic field sensor as defined in claim 5 wherein the first and second epitaxial layers have an interface and said layers have a composition gradient at and perpendicular to said interface, where aluminum content decreases and gallium content correspondingly increases in said first epitaxial layer approaching said interface, and where aluminum content increases and gallium content correspondingly decreases in said second epitaxial layer approaching said interface.

7. The magnetic field sensor as defined in claim 1 wherein the substrate is a composite wafer.

8. The magnetic field sensor as defined in claim 1 wherein the magnetic field sensor is a magnetoresistor, the first epitaxial layer is about 0.5 to 2.0 micrometer thick, the first compound semiconductor material is $Al_yIn_{1-y}Sb$, where "y" is less than about 0.2, the second epitaxial layer is less than about 0.5 micrometer thick, the second compound semiconductor material is $Ga_xIn_{1-x}Sb$, where "x" is less than about 0.2, and where "1.12 times x" and "y" do not differ by more than about 0.1.

9. The magnetic field sensor as defined in claim 1 wherein the magnetic field sensor is a magnetoresistor, the first epitaxial layer is at least about 0.5 to 2.0 micrometer thick, the first compound semiconductor material is $Al_yIn_{1-y}Sb$, where "y" is less than about 0.2, the second epitaxial layer is less than about 0.5 micrometer thick, the second compound semiconductor material is $Ga_xIn_{1-x}Sb$, where "x" is less than about 0.2, and "1.12 times x" and "y" are at least substantially equal.

10. The magnetic field sensor of claim 9 wherein the first epitaxial layer has a deep level and/or p-type doping to increase its sheet resistivity or sheet resistance and the thickness of the second epitaxial layer is about 0.04 to 0.5 micrometer.

11. The magnetic field sensor as defined in claim 1 wherein the first epitaxial layer is at least about 0.5 micrometer thick, the first compound semiconductor material is $Al_yIn_{1-y}Sb$, where "y" is less than about 0.3, the second epitaxial layer is less than about 0.5 micrometer thick, and the second compound semiconductor material is $InAs_xSb_{1-x}$ where "x" is less than about 0.25.

12. The magnetic field sensor as defined in claim 1 wherein the magnetic field sensor is a magnetoresistor, the first epitaxial layer is at least about 0.5 to 2.0 micrometer thick, the first compound semiconductor material is $Al_yIn_{1-y}Sb$, where "y" is less than about 0.2, the second epitaxial layer is less than about 0.5 micrometer thick, and the second compound semiconductor material is $InAs_xSb_{1-x}$ where "x" is less than about 0.1 and "1.23 times x" and "y" are substantially equal.

13. The magnetic field sensor as defined in claim 1 wherein the first epitaxial layer is at least about 0.5 micrometer thick, the first compound semiconductor material is $Al_yIn_{1-y}Sb$, where "y" is less than about 0.3, the second epitaxial layer is less than about 0.5 micrometer thick, and the second compound semiconductor material is $In_{1-x}Al_xSb$ where "x" is less than about 0.05.

14. The magnetic field sensor as defined in claim 1 wherein the magnetic field sensor is a magnetoresistor, the first epitaxial layer is at least about 0.5 to 2.0 micrometer thick, the first compound semiconductor material is $Al_yIn_{1-y}Sb$, where "y" is less than about 0.15, the second epitaxial layer is less than about 0.5 micrometer thick, and the second compound semiconductor material is $In_{1-x}Al_xSb$ where "x" is less than about 0.05.

15. The magnetic field sensor as defined in claim 14 wherein the first and second epitaxial layers have an interface and said layers have a composition gradient at and perpendicular to said interface, where aluminum content decreases and indium content correspondingly increases in said first epitaxial layer approaching said interface, and where aluminum content increases and indium content correspondingly decreases in said second epitaxial layer approaching said interface.

16. A high magnetic sensitivity compound semiconductor magnetic field sensor that can be fabricated in smaller areal geometries with high sensor electrical resistance, said compound semiconductor magnetic field sensor comprising:

    a monocrystalline substrate of a semiconductor selected from the class consisting of silicon, germanium, gallium arsenide, and indium phosphide, said substrate having a substantially planar and at least semi-insulated monocrystalline surface portion;

    a first epitaxial layer disposed on said substrate surface of a first compound semiconductor of said crystal type, said layer being about 0.1 to 2.0 micrometers thick and having an exposed surface with a dislocation density less than about $3 \times 10^9$ cm$^{-2}$, said first compound semiconductor having a lattice constant of at least about 6.3 angstroms and a given energy band gap higher than about 0.2 eV;

    a second epitaxial layer of a second compound semiconductor disposed on said exposed surface of said first epitaxial layer, said second compound semiconductor of said crystal type and having a lattice constant closely matching that of said first compound semiconductor material but having a lower energy band gap, an areal mobility in excess of 30,000 cm$^2$V$^{-1}$s$^{-1}$, and a sheet resistance lower than about one-tenth the sheet resistance of said first epitaxial layer;

    said second epitaxial layer being an elongated mesa on said first epitaxial layer and having a thickness less than about 0.5 micrometer; and

    electrical contacts to opposite ends of said mesa,

    effective to provide a magnetic field sensor which affords low power consumption per unit sensor area and high spatial resolution in sensing.

17. The magnetic field sensor as defined in claim 16 wherein the first compound semiconductor material is indium aluminum antimonide and the second compound semiconductor material is indium gallium antimonide, indium arsenide antimonide or aluminum indium antimonide.

18. The magnetic field sensor as defined in claim 16 wherein the first epitaxial layer is a laminate of a plurality of semiconductors.

19. The magnetic field sensor as defined in claim 18 wherein the laminate is a super lattice.

20. The magnetic field sensor as defined in claim 16 wherein doping in the first epitaxial layer is used for modulated doping of the second epitaxial layer, effective to stabilize the second epitaxial layer against conductivity changes due to temperature change without chemically doping said second epitaxial layer and coincidentally reducing electron mobility in said second epitaxial layer.

21. The magnetic field sensor as defined in claim 16 wherein the magnetic field sensor is a magnetoresistor, the first epitaxial layer is about 0.5 to 2.0 micrometer thick, the first compound semiconductor material is $Al_yIn_{1-y}Sb$, where "y" is less than about 0.2, the second epitaxial layer is about 400 to 1500 angstroms thick, the second compound semiconductor material is $Ga_xIn_{1-x}Sb$, where "x" is less than about 0.2, and "1.12 times x" and "y" are substantially equal.

22. The magnetic field sensor as defined in claim 21 wherein doping in the first epitaxial layer is used for modulated doping of the second epitaxial layer, effective to stabilize the second epitaxial layer against conductivity changes due to temperature change without chemically doping said second epitaxial layer and coincidentally reducing electron mobility in said second epitaxial layer.

23. The magnetic field sensor as defined in claim 16 wherein the magnetic field sensor is a magnetoresistor, the first epitaxial layer is about 0.5 to 2.0 micrometer thick, the first compound semiconductor material is $Al_yIn_{1-y}Sb$, where "y" is less than about 0.2, the second epitaxial layer is about 400 to 1500 angstroms thick, the second compound semiconductor material is $InAs_xSb_{1-x}$, where "x" is less than about 0.2, and "1.23 times x" and "y" are substantially equal.

24. The magnetic field sensor as defined in claim 16 wherein the magnetic field sensor is a magnetoresistor, the first epitaxial layer is about 0.5 to 2.0 micrometer thick, the first compound semiconductor material is $Al_yIn_{1-y}Sb$, where "y" is less than about 0.15, the second epitaxial layer is about 400 to 1500 angstroms thick, and the second compound semiconductor material is $Al_xIn_{1-x}Sb$, where "x" is less than about 0.06.

25. The magnetic field sensor as defined in claim 24 wherein doping in the first epitaxial layer is used for modulated doping of the second epitaxial layer effective to stabilize the second epitaxial layer against conductivity changes due to temperature change without chemically doping said second epitaxial layer and coincidentally reducing electron mobility in said second epitaxial layer.

26. The magnetic field sensor as defined in claim 17 in which one or two additional electrical contacts are added around the periphery of said mesa to enable a Hall effect or MAGFET sensor to be made.

27. The magnetic field sensor as defined in claim 17 in which said second epitaxial layer is perforated with a large number of holes, said holes being less than one micrometer in diameter and disposed in a random, semi-random, or ordered array.

# FIG - 1

# FIG - 2

# FIG - 5

20a  20b  20c

FIG - 3A
PRIOR ART

20  20

10a  10d

10b  10e

10c  10f

20d  20e

18

16

FIG - 3B

14  20b  20c  14

20a

12

12  10d

10a  10e

10b  10f

10c  20e

20d

16  18

FIG - 4

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP-A-0 548 375 (ASAHI CHEMICAL IND) 30 June 1993<br>* page 4, line 1 - page 7, line 16 * | 1-4 | H01L43/06<br>H01L43/08 |
| A | | 5,8-14,<br>16,17,<br>21,23,<br>24,26 | |
| A | US-A-5 184 106 (PARTIN DALE L ET AL) 2 February 1993<br><br>* column 3, line 13 - column 5, line 2 *<br>* column 9, line 44 - line 56 * | 1,2,7,9,<br>10,16,<br>17,26 | |
| A | JOURNAL OF VACUUM SCIENCE AND TECHNOLOGY: PART B,<br>vol. 11, no. 3, May 1993 - June 1993 NEW YORK US,<br>pages 872-874,<br>L.K. LI ET AL 'Molecular-beam epitaxial growth of InSb on GaAs and Si for infrared detector applications'<br>* abstract * | 1,16 | |
| D,A | EP-A-0 443 660 (GEN MOTORS CORP) 28 August 1991<br>* the whole document * | 1,16,17,<br>27 | |

TECHNICAL FIELDS SEARCHED (Int.Cl.6)

H01L

The present search report has been drawn up for all claims

| Place of search | Date of completion of the search | Examiner |
|---|---|---|
| THE HAGUE | 19 July 1995 | De Laere, A |

EPO FORM 1503 03.82 (P04C01)